# EUROPEAN PATENT APPLICATION

(11) **EP 3 118 891 A1**
(43) Date of publication of application: **18.01.2017**
(21) Application number: 15761829.9
(22) Date of filing: 11.03.2015
(51) Int. Cl.: H01L 21/312, C08F 20/56, H01L 21/28, H01L 21/336, H01L 29/786, H01L 51/05, H01L 51/30

(54) **COMPOSITION AND ORGANIC THIN-FILM TRANSISTOR USING SAME**

(30) Priority: 13.03.2014 JP 2014049874
(71) Applicant: Sumitomo Chemical Company Limited, Tokyo 104-8260 (JP)
(72) Inventor: YAHAGI, Isao, Tsukuba-shi Ibaraki 300-3294 (JP)
(74) Representative: Newman, Alastair James Morley
(86) International application number: PCT/JP2015/057968
(87) International publication number: WO 2015/137522

(57) **Abstract**

A composition comprising a polymer compound (A) containing a repeating unit having a group represented by the formula (1), a compound (B) decomposing to generate an acid by irradiation with an electromagnetic wave or an electronic beam or by heating, and a compound (C) reacting with a hydroxyl group in the presence of an acid: 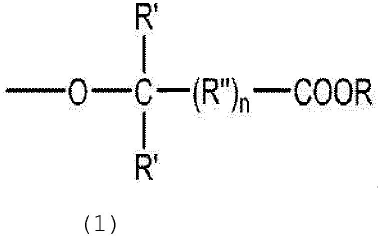 [wherein R represents a monovalent organic group showing an activation energy in dissociating from an oxygen atom by the action of an acid of 80 kJ or less. R' represents an alkyl group and the like. n represents an integer of 0 or more. R" represents an alkylene group and the like.].

## Description

### Technical Field

The present invention relates to a composition and an organic film transistor using the same.

### Background Art

Organic film transistors using an organic semiconductor material can use flexible substrates typified by a plastic substrate since the organic film transistors can be produced at lower temperature as compared with conventional film transistors using an inorganic semiconductor material. Further, by using a polymer compound as the organic semiconductor material, a film can be formed by application methods typified by a spin coat method and an inkjet printing method, thus, a simple production process is possible. Therefore, organic film transistors using an organic semiconductor material are actively studied and developed.

A field-effect organic film transistor which is one of organic film transistors has a gate electrode, a source electrode, a drain electrode, an organic semiconductor layer and a gate insulating layer.

A bottom gate type field-effect organic film transistor usually has an overcoat layer (referred to also as a protective layer) for isolating an organic semiconductor layer from the outside air, since the organic semiconductor layer is situated at the uppermost layer of the organic film transistor. Meanwhile, in a top gate type field-effect organic film transistor, a gate insulating layer usually functions also as an overcoat layer, since the gate insulating layer is situated at the uppermost layer of the organic film transistor.

For connecting a drain electrode of an organic film transistor and an electrode of a display device, a via hole (referred to also as a contact hole or a through hole) is formed on a gate insulating layer or an overcoat layer.

As the material used in a gate insulating layer of an organic film transistor, a composition containing an epoxy resin and a silane coupling agent is known (Patent document 1).

Further, as the material used in a gate insulating layer of an organic film transistor, a composition containing polyvinylphenol and a melamine compound is known (Non-patent document 1).

### Prior Art Document

### Patent Document

Patent document 1: JP-A No. 2007-305950

### Non-patent Document

Non-patent document 1: Appl. Phys. Lett. 89, 093507 (2006)

### Summary of the Invention

However, in the case of forming via holes on a gate insulating layer or an overcoat layer formed of the above-described material, the process was complicated.

That is, a step of forming a resist layer on a gate insulating layer or an overcoat layer, a step of exposing a part or several parts of the resist layer with UV, a step of patterning the resist layer by performing development, a step of etching the gate insulating layer or the overcoat layer and a step of peel-removing the resist layer after etching were necessary, thus, the process of forming via holes was complicated.

Then, the present invention has an object of providing a material capable of forming via holes on a gate insulating layer or an overcoat layer by a simple process.

The present invention provides a composition described below, a method of producing a film using the composition, a film produced by the production method, an organic film transistor having the film in its insulating layer, and a polymer compound contained in the composition.

[1] A composition comprising a polymer compound (A) containing a repeating unit having a group represented by the following formula (1), a compound (B) decomposing to generate an acid by irradiation with an electromagnetic wave or an electronic beam or by heating, and a compound (C) reacting with a hydroxyl group in the presence of an acid: 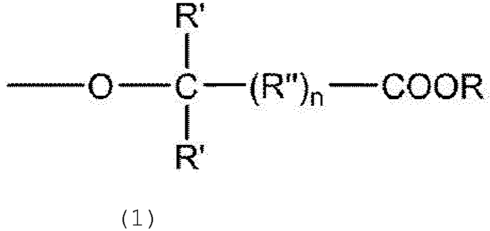 [wherein
   R represents a monovalent organic group showing an activation energy in dissociating from an oxygen atom by the action of an acid of 80 kJ or less.
   R' represents an alkyl group or a cycloalkyl group, and these groups may have a substituent. A plurality of R' may be the same or different, and may be combined together to form a ring together with a carbon atom to which they are attached.
   n represents an integer of 0 or more.
   R" represents an alkylene group, a cycloalkylene group or an arylene group, and these groups may have a substituent. When there are a plurality of R", they may be the same or different. R' and R" may be combined together to form a ring together with a carbon atom to which they are attached.].
[2] The composition according to [1], wherein the repeating unit having a group represented by the above-described formula (1) is a repeating unit represented by the following formula (2) : 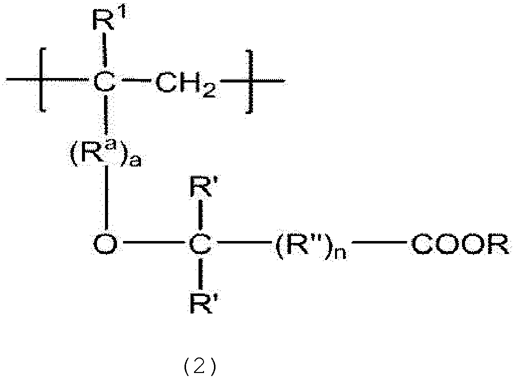 [wherein
   R, R', R" and n represent the same meaning as described above.
   R¹ represents a hydrogen atom or a methyl group.
   a represents an integer of 0 or more.
   R^{a} represents an alkylene group, a cycloalkylene group, an arylene group, a group represented by -CO-, a group represented by -COO-, a group represented by -NHCO- or a group represented by -NHCOO-, and these groups may have a substituent. When there are a plurality of R^{a}, they may be the same or different.].
[3] The composition according to [1] or [2], wherein the above-described compound (B) is a sulfonic acid ester compound, a triazine compound, a sulfonium salt or an iodonium salt.
[4] The composition according to any one of [1] to [3], wherein the above-described compound (C) is a melamine compound or a urea compound.
[5] The composition according to any one of [1] to [4], further comprising a solvent.
[6] A method of producing a film, comprising a step of applying the composition according to [5] on a substrate, to form a film, a step of irradiating a part or several parts of the film with an electromagnetic wave or an electronic beam, a step of developing the part or several parts of the film irradiated with an electromagnetic wave or an electronic beam, thereby patterning the film, and a step of heating the patterned film, thereby cross-linking a compound contained in the film.
[7] A method of producing a film, comprising step of applying the composition according to [5] on a substrate, to form a film, a step of irradiating a part or several parts of the film with an electromagnetic wave or an electronic beam, a step of developing the part or several parts of the film irradiated with an electromagnetic wave or an electronic beam, thereby patterning the film, a step of irradiating the patterned film with an electromagnetic wave or an electronic beam, then, heating the film, thereby cross-linking a compound contained in the film.
[8] The method of producing a film according to [6] or [7], wherein the above-described electromagnetic wave is ultraviolet radiation.
[9] A film produced by the production method according to any one of [6] to [8].
[10] An organic film transistor having the film according to [9] in an insulating layer.
[11] The organic film transistor according to [10], wherein the above-described insulating layer is a gate insulating layer and/or an overcoat layer.
[12] A polymer compound comprising a repeating unit having a group represented by the following formula (1): 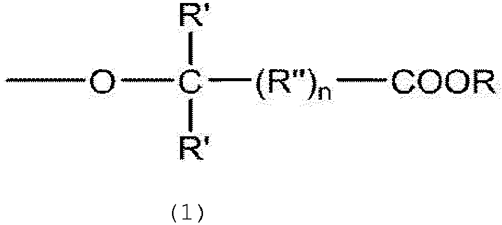 [wherein
   R represents a monovalent organic group showing an activation energy in dissociating from an oxygen atom by the action of an acid of 80 kJ or less.
   R' represents an alkyl group or a cycloalkyl group, and these groups may have a substituent. A plurality of R' may be the same or different, and may be combined together to form a ring together with a carbon atom to which they are attached.
   R" represents an alkylene group, a cycloalkylene group or an arylene group, and these groups may have a substituent. When there are a plurality of R", they may be the same or different. R' and R" may be combined together to form a ring together with a carbon atom to which they are attached.].

### Brief Explanation of Drawings

Fig. 1 is a schematic cross-sectional view showing the structure of a bottom gate top contact type organic film transistor as one embodiment of the present invention.
Fig. 2 is a schematic cross-sectional view showing the structure of a bottom gate bottom contact type organic film transistor as another embodiment of the present invention.

### Modes for Carrying Out the Invention

Suitable embodiments of the present invention will be illustrated in detail, if necessary referring to drawings, below. In explanation of drawings, the same elements are denoted by the same reference numerals, and duplicated explanations are omitted.

### <Explanation of common terms>

Hereinafter, terms commonly used in the present specification have the following means unless otherwise stated.

"Polymer compound" means a compound containing two or more identical structural units in the molecule, and "repeating unit" denotes a structural unit occurring twice or more in the molecule. Also what is called a dimer corresponds to the polymer compound. The polystyrene-equivalent number-average molecular weight of the polymer compound is usually 1×10³ to 1×10⁸.

Meanwhile, "low molecular weight compound" means a compound not containing two or more identical structural units in the molecule.

The polymer compound may be any of a homopolymer; and a copolymer such as a block copolymer, a random copolymer, an alternating copolymer, a graft copolymer and the like; and may take any other embodiment.

The alkyl group may be any of a linear alkyl group and a branched alkyl group. The linear alkyl group has a number of carbon atoms of usually 1 to 30, and the branched alkyl group has a number of carbon atoms of usually 3 to 30. The number of carbon atoms of the alkyl group does not include the number of carbon atoms of a substituent. The cycloalkyl group has a number of carbon atoms of usually 3 to 30. The number of carbon atoms of the cycloalkyl group does not include the number of carbon atoms of a substituent.

The alkyl group includes, for example, linear alkyl groups such as a methyl group, an ethyl group, a n-propyl group, a n-butyl group, a n-hexyl group, a n-octyl group, a n-dodecyl group, a n-hexadecyl group and the like, branched alkyl groups such as an isopropyl group, an isobutyl group, a sec-butyl group, a tert-butyl group, a 2-ethylhexyl group, a 3,7-dimethyloctyl group, a 2-hexyldecyl group, a 2-octyldodecyl group, a 2-decyltetradecyl group and the like. The cycloalkyl group includes, for example, a cyclopentyl group and a cyclohexyl group.

The alkyl group may have a substituent, and the substituent includes a cycloalkyl group, an alkoxy group, a cycloalkoxy group, an aryl group and a halogen atom. The cycloalkyl group may have a substituent, and the substituent includes an alkyl group, a cycloalkyl group, an alkoxy group, a cycloalkoxy group, an aryl group and a halogen atom. The alkyl group having a substituent includes, for example, a methoxyethyl group, a benzyl group, a trifluoromethyl group and a perfluorohexyl group.

The alkoxy group may be any of a linear alkoxy group and a branched alkoxy group. The linear alkoxy group has a number of carbon atoms of usually 1 to 30, and the branched alkoxy group has a number of carbon atoms of usually 3 to 30. The number of carbon atoms of the alkoxy group does not include the number of carbon atoms of a substituent. The cycloalkoxy group has a number of carbon atoms of usually 3 to 30. The number of carbon atoms of the cycloalkoxy group does not include the number of carbon atoms of a substituent.

The alkoxy group includes, for example, linear alkoxy groups such as a methoxy group, an ethoxy group, a n-propyloxy group, a n-butyloxy group, a n-hexyloxy group, a n-octyloxy group, a n-dodecyloxy group, a n-hexadecyloxy group and the like, branched alkoxy groups such as an isopropyloxy group, an isobutyloxy group, a sec-butyloxy group, a tert-butyloxy group, a 2-ethylhexyloxy group, a 3,7-dimethyloctyloxy group, a 2-hexyldecyloxy group, a 2-octyldodecyloxy group, a 2-decyltetradecyloxy group and the like. The cycloalkoxy group includes, for example, a cyclopentyloxy group and a cyclohexyloxy group.

The alkoxy group may have a substituent, and the substituent includes a cycloalkyl group, an alkoxy group, a cycloalkoxy group, an aryl group and a halogen atom. The cycloalkoxy group may have a substituent, and the substituent includes an alkyl group, a cycloalkyl group, an alkoxy group, a cycloalkoxy group, an aryl group and a halogen atom.

The aryl group is an atomic group remaining after removing from an aromatic hydrocarbon one hydrogen atom directly linking to a carbon atom constituting the ring. The aromatic hydrocarbon has a number of carbon atoms of usually 6 to 60, preferably 6 to 20. The number of carbon atoms of the aromatic hydrocarbon group does not include the number of carbon atoms of a substituent.

The aromatic hydrocarbon includes benzene, hydrocarbon condensed ring compounds containing benzene, and compounds obtained by directly bonding two or more selected from the group consisting of benzene and hydrocarbon condensed ring compounds containing benzene.

The aryl group includes, for example, a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group and a 4-phenylphenyl group.

The aryl group may have a substituent, and the substituent includes an alkyl group, a cycloalkyl group, an alkoxy group, a cycloalkoxy group, a monovalent heterocyclic group and a halogen atom, and an alkyl group or a cycloalkyl group is preferable and an alkyl group is more preferable.

The monovalent heterocyclic group is an atomic group remaining after removing from a heterocyclic compound one hydrogen atom linking directly to a carbon atom constituting the ring. The heterocyclic compound has a number of carbon atoms of usually 2 to 30, preferably 3 to 20. The number of carbon atoms of the monovalent heterocyclic group does not include the number of carbon atoms of a substituent. The monovalent heterocyclic group is preferably a monovalent aromatic heterocyclic group.

The heterocyclic compound includes organic compounds having a cyclic structure in which the element constituting the ring includes not only a carbon atom but also a hetero atom such as an oxygen atom, a sulfur atom, a selenium atom, a nitrogen atom, a phosphorus atom, a boron atom, an arsenic atom and the like contained in the ring.

The heterocyclic compound includes monocyclic heterocyclic compounds, condensed ring compounds containing a heterocyclic compound, and compounds obtained by directly bonding two or more selected from the group consisting of monocyclic heterocyclic compounds and condensed ring compounds containing a heterocyclic compound.

The monovalent heterocyclic group may have a substituent, and the substituent includes an alkyl group, a cycloalkyl group, an alkoxy group, a cycloalkoxy group, an aryl group and a halogen atom, and an alkyl group or a cycloalkyl group is preferable and an alkyl group is more preferable.

The monovalent heterocyclic group includes, for example, a 2-furyl group, a 3-furyl group, a 2-thienyl group, a 3-thienyl group, a 2-pyrrolyl group, a 3-pyrrolyl group, a 2-oxazolyl group, a 2-thiazolyl group, a 2-imidazolyl group, a 2-pyridyl group, a 3-pyridyl group, a 4-pyridyl group, a 2-benzofuryl group, a 2-benzothienyl group, a 2-thienothienyl group and a 4-(2,1,3-benzothiadiazolyl) group.

The halogen atom includes a fluorine atom, a chlorine atom, a bromine atom and an iodine atom.

The alkylene group may be any of a linear alkylene group or a branched alkylene group. The linear alkylene group has a number of carbon atoms of usually 1 to 20, and the branched alkylene group has a number of carbon atoms of usually 3 to 20. The number of carbon atoms of the alkylene group does not include the number of carbon atoms of a substituent. The cycloalkylene group has a number of carbon atoms of usually 3 to 20 . The number of carbon atoms of the cycloalkylene group does not include the number of carbon atoms of a substituent.

The alkylene group may have a substituent, and the substituent includes an alkyl group, a cycloalkyl group, an alkoxy group, a cycloalkoxy group, a cyano group, an alkylcarbonyl group, a cycloalkylcarbonyl group, an alkylcarbonyloxy group, a cycloalkylcarbonyloxy group, an alkyloxycarbonyl group and a cycloalkyloxycarbonyl group.

The alkylene group includes, for example, a methylene group, an ethylene group, a propylene group, a butylene group, a pentylene group, a hexylene group, an isopropylene group, an isobutylene group and a dimethylpropylene group. The cycloalkylene group includes, for example, a cyclopropylene group, a cyclobutylene group, a cyclopentylene group and a cyclohexylene group.

The arylene group is an atomic group remaining after removing from an aromatic hydrocarbon two hydrogen atoms linking directly to a carbon atom constituting the ring. The aromatic hydrocarbon has a number of carbon atoms of usually 6 to 20.

The number of carbon atoms of the arylene group does not include the number of carbon atoms of a substituent. The arylene group may have a substituent, and the substituent includes an alkyl group, a cycloalkyl group, an alkoxy group, a cycloalkoxy group, an aryl group, a monovalent heterocyclic group and a halogen atom, and an alkyl group or a cycloalkyl group is preferable and an alkyl group is more preferable.

The arylene group includes, for example, a phenylene group, a naphthylene group, an anthrylene group, a dimethylphenylene group, a trimethylphenylene group, a phenylenemethylene group, a phenylenedimethylene group, a phenylenetrimethylene group, a phenylenetetramethylene group, a methylnaphthylene group, a dimethylnaphthylene group, a trimethylnaphthylene group, a vinylnaphthylene group, an ethenylnaphthylene group, a methylanthrylene group and an ethylanthrylene group.

### <Composition>

The composition of the present invention comprises a polymer compound (A), a compound (B) and a compound (C).

### <Polymer compound (A)>

The polymer compound (A) contains a repeating unit having a group represented by the following formula (1).

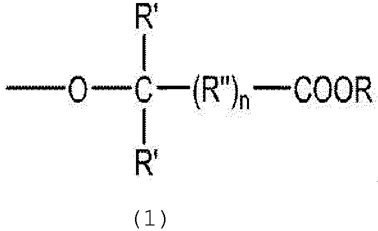

In the formula (1), R represents a monovalent organic group capable of dissociating from an oxygen atom by the action of an acid.

Preferably, R represents a monovalent organic group showing an activation energy in dissociating from an oxygen atom by the action of an acid of 80 kJ or less. That is, it is preferable that R is a monovalent organic group in which the activation energy in desorbing R from an oxygen atom to generate a group represented by -COOH is 80 kJ or less.

The activation energy in dissociating from an oxygen atom by the action of an acid can be measured, for example, by differential scanning calorimetry.

Preferably, R represents a monovalent organic group capable of dissociating from an oxygen atom by the action of an acid at a temperature of less than 100°C.

When an acid acts on a group represented by -COOR, R desorbs from an oxygen atom to generate a group represented by -COOH. In this case, the polymer compound (A) shows acidity, resulting in an improvement in solubility in an alkaline solution.

The monovalent organic group capable of dissociating from an oxygen atom by the action of an acid includes, for example, a hydrofuranyl group, a hydropyranyl group, an alkyl group having as a substituent an alkoxy group or a cycloalkoxy group, and a cycloalkyl group having as a substituent an alkoxy group or a cycloalkoxy group, and these groups may have a substituent.

The activation energy in dessociating from an oxygen atom by the action of an acid of the monovalent organic group exemplified above is 80 kJ or less. The monovalent organic group exemplified above is usually capable of dissociating from an oxygen atom by the action of an acid at a temperature of less than 100°C.

The substituent which a hydrofuranyl group and a hydropyranyl group may have includes, for example, a hydroxyl group, an alkoxy group, a cycloalkoxy group, an alkyl group and a cycloalkyl group.

The hydrofuranyl group denotes a group obtained by removing one hydrogen atom linking directly to a carbon atom constituting the ring of dihydrofuran or tetrahydrofuran, and the substituent which the hydrofuranyl group may have includes an alkyl group, a cycloalkyl group, an alkoxy group, a cycloalkoxy group and a hydroxyl group.

The hydrofuranyl group includes, for example, a dihydrofuranyl group and a tetrahydrofuranyl group.

The hydropyranyl group denotes a group obtained by removing one hydrogen atom linking directly to a carbon atom constituting the ring of dihydropyran or tetrahydropyran, and the substituent which the hydrofuranyl group may have includes an alkyl group, a cycloalkyl group, an alkoxy group, a cycloalkoxy group and a hydroxyl group.

The hydropyranyl group includes, for example, a dihydropyranyl group, a tetrahydropyranyl group and a 4-methoxytetrahydropyranyl group.

The substituent which the alkyl group having as a substituent an alkoxy group or a cycloalkoxy group and the cycloalkyl group having as a substituent an alkoxy group or a cycloalkoxy group may further have includes, for example, an ethyl group and a propyl group.

The alkyl group having as a substituent an alkoxy group includes, for example, a 1-methoxyethyl group, a 1-ethoxyethyl group, a 1-methoxypropyl group and a 1-ethoxypropyl group.

R is preferably a tetrahydro-2-pyranyl group.

In the formula (1), R' represents an alkyl group or a cycloalkyl group, and these groups may have a substituent. R' is preferably an alkyl group.

A plurality of R' may be combined together to form a ring together with a carbon atom to which they are attached. The ring to be formed includes, for example, a cyclopropane ring (corresponding to a cyclopropylene group), a cyclobutane ring (corresponding to a cyclobutylene group), a cyclopentane ring (corresponding to a cyclopentylene group) and a cyclohexane ring (corresponding to a cyclohexylene group).

It is preferable that R' is a methyl group, and it is more preferable that both R' are a methyl group.

That is, it is more preferable that the group represented by 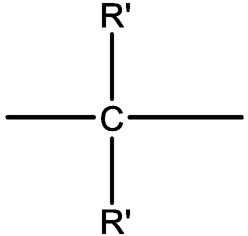 in the formula (1) is a dimethylmethylene group.

In the formula (1), n represents an integer of 0 or more. n is preferably 1.

In the formula (1), R" represents an alkylene group, a cycloalkylene group or an arylene group, and these groups may have a substituent. R" is preferably an alkylene group.

R' and R" may be combined together to form a ring together with a carbon atom to which they are attached.

The ring to be formed includes a monocyclic ring, a condensed polycyclic ring and a bridged ring. The ring to be formed may have a substituent such as an alkyl group and the like.

The ring to be formed includes a cyclopropane ring, a cyclobutane ring, a cyclopentane ring and an adamantane ring.

The group represented by 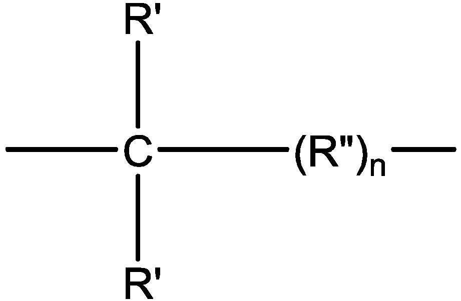 in the formula (1) includes the following groups.

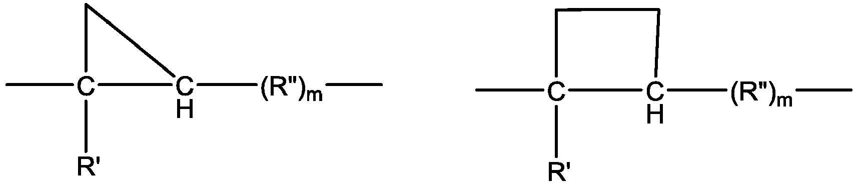

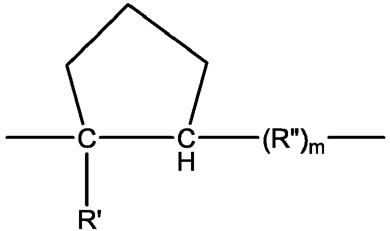

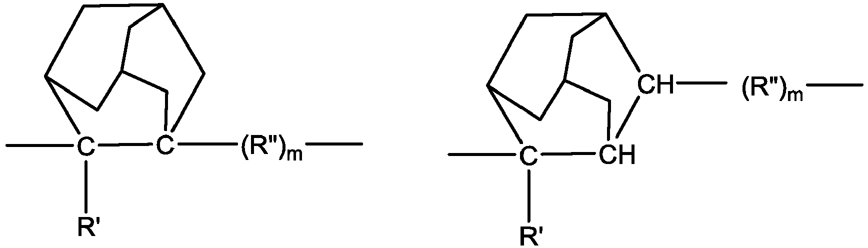

In the formulae, R' and R" each represent the same meaning as described above, and m represents an integer of 0 or more. When there are a plurality of R', they may be the same or different. When there are a plurality of R", they may be the same or different.

R' includes alkyl groups such as a methyl group, an ethyl group and the like.

m is preferably 0.

The group represented by 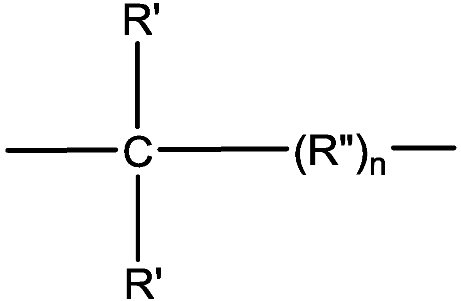
in the formula (1) more specifically includes, for example,
a 1-methyl-1,2-cyclopropylene group, a
1-ethyl-1,2-cyclopropylene group, a
1-methyl-1,2-cyclopropylene group, a
1-ethyl-1,2-cyclobutylene group, a
1-methyl-1,2-cyclobutylene group, a
1-ethyl-1,2-cyclopentylene group, a
1-methyl-1,2-cyclopentylene group, a
1-ethyl-1,2-cyclopentylene group, a
2-methyl-1,2-adamantanediyl group, a
2-ethyl-1,2-adamantanediyl group, a
2-methyl-2,4-adamantanediyl group and a
2-ethyl-2,4-adamantanediyl group.

The repeating unit having a group represented by the formula (1) is preferably a repeating unit represented by the following formula (2).

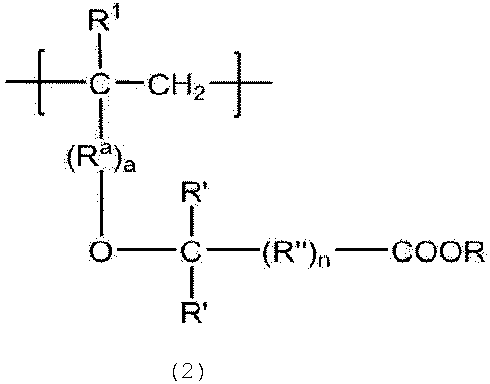

In the formula (2), R¹ represents a hydrogen atom or a methyl group. R¹ is preferably a hydrogen atom.

In the formula (2), a represents an integer of 0 or more. a is preferably 1.

In the formula (2), R^{a} represents an alkylene group, a cycloalkylene group, an arylene group, a group represented by -CO-, a group represented by -COO-, a group represented by -NHCO- or a group represented by -NHCOO-. R^{a} is preferably an alkylene group, a cycloalkylene group or an arylene group, more preferably an alkylene group or an arylene group.

The alkylene group represented by R^{a} includes, for example, a methylene group, an ethylene group, a propylene group, a butylene group, a pentylene group, a hexylene group, an isopropylene group, an isobutylene group and a dimethylpropylene group.

The cycloalkylene group represented by R^{a} includes, for example, a cyclopropylene group, a cyclobutylene group, a cyclopentylene group and a cyclohexylene group.

The arylene group represented by R^{a} includes, for example, a phenylene group, a naphthylene group, an anthrylene group, a dimethylphenylene group, a trimethylphenylene group, a phenylenemethylene group, a phenylenedimethylene group, a phenylenetrimethylene group, a phenylenetetramethylene group, a methylnaphthylene group, a dimethylnaphthylene group, a trimethylnaphthylene group, a vinylnaphthylene group, an ethenylnaphthylene group, a methylanthrylene group and an ethylanthrylene group, and a phenylene group is preferable since the dielectric tangent of a gate insulating layer or an overcoat layer obtained by using the composition of the present invention is excellent.

The polymer compound (A) can be produced, for example, by polymerizing (homopolymerizing or copolymerizing) a polymerizable monomer which is used as the raw material of a repeating unit having a group represented by the formula (1), in the presence of a photopolymerization initiator or a thermal polymerization initiator. The polymerizable monomer which is used as the raw material of a repeating unit having a group represented by the formula (1) is preferably a polymerizable monomer which is used as the raw material of a repeating unit represented by the formula (2).

The photopolymerization initiator includes, for example, carbonyl compounds such as acetophenone, 2,2-dimethoxy-2-phenylacetophenone, 2,2-diethoxyacetophenone, 4-isopropyl-2-hydroxy-2-methylpropiophenone, 2-hydroxy-2-methylpropiophenone, 4,4'-bis(diethylamino)benzophenone, benzophenone, methyl (o-benzoyl) benzoate, 1-phenyl-1,2-propanedione-2-(o-ethoxycarbonyl)oxime, 1-phenyl-1,2-propanedione-2-(o-benzoyl)oxime, benzoin, benzoin methyl ether, benzoin ethyl ether, benzoin isopropyl ether, benzoin isobutyl ether, benzoin octyl ether, benzyl, benzyl dimethyl ketal, benzyl diethyl ketal, diacetyl and the like; anthraquinone derivatives and thioxanthone derivatives such as methylanthraquinone, chloroanthraquinone, chlorothioxanthone, 2-methylthioxanthone, 2-isopropylthioxanthone and the like; and sulfur compounds such as diphenyl disulfide, dithiocarbamate and the like.

In the case of use of optical energy as the energy for initiating polymerization (homopolymerization or copolymerization), the wavelength of light irradiating a polymerizable monomer is usually 360 nm or more, preferably 360 nm or more and 450 nm or less.

The thermal polymerization initiator may be a compound acting as an initiator of radical polymerization, and includes, for example, azo compounds such as 2,2'-azobisisobutyronitrile, 2,2'-azobisisovaleronitrile, 2,2'-azobis(2,4-dimethylvaleronitrile), 4,4'-azobis(4-cyanovaleric acid), 1, 1'-azobis(cyclohexanecarbonitrile), 2,2'-azobis(2-methylpropane), 2,2'-azobis(2-methylpropionamidine) dihydrochloride and the like; ketone peroxide compounds such as methyl ethyl ketone peroxide, methyl isobutyl ketone peroxide, cyclohexanone peroxide, acetylacetone peroxide and the like; diacyl peroxide compounds such as isobutyl peroxide, benzoyl peroxide, 2,4-dichlorobenzoyl peroxide, o-methylbenzoyl peroxide, lauroyl peroxide, p-chlorobenzoyl peroxide and the like; hydroperoxide compounds such as 2,4,4-trimethylpentyl-2-hydroperoxide, diisopropylbenzene hydroperoxide, cumene hydroperoxide, tert-butyl hydroperoxide and the like; dialkyl peroxide compounds such as dicumyl peroxide, tert-butyl cumyl peroxide, di-tert-butyl peroxide, tris(tert-butylperoxy)triazine and the like; peroxy ketal compounds such as 1,1-di-tert-butylperoxycyclohexane, 2,2-di(tert-butylperoxy)butane and the like; alkyl perester compounds such as tert-butyl peroxypivalate, tert-butyl peroxy-2-ethylhexanoate, tert-butyl peroxyisobutyrate, di-tert-butyl peroxyhexahydroterephthalate, di-tert-butyl peroxyazelate, tert-butyl peroxy-3,5,5-trimethylhexanoate, tert-butyl peroxyacetate, tert-butyl peroxybenzoate, di-tert-butyl peroxytrimethyladipate and the like; and peroxy carbonate compounds such as diisopropylperoxy dicarbonate, di-sec-butylperoxy dicarbonate, tert-butylperoxyisopropyl carbonate and the like.

The monomer which is used as the raw material of a repeating unit represented by the formula (2) includes, for example, 4-[dimethyl(2-pyranyl-oxycarbonyl)]methyloxystyrene, α-methyl-4-[dimethyl(2-pyranyl-oxycarbonyl)]methyloxybenzyl methacrylate, 4-[1,1-dimethyl-2-(2-pyranyl-oxycarbonyl)]ethyloxystyrene and α-methyl-4-[1,1-dimethyl-2-(2-pyranyl-oxycarbonyl)]ethyloxy benzyl methacrylate.

The polymer compound (A) may also be produced by copolymerizing a polymerizable monomer which is used as the raw material of a repeating unit having a group represented by the formula (1) and a polymerizable monomer which is used as the raw material of another repeating unit. The polymerizable monomer which is used as the raw material of a repeating unit having a group represented by the formula (1) is preferably a polymerizable monomer which is used as the raw material of a repeating unit represented by the formula (2).

The polymerizable monomer which is used as the raw material of another repeating unit includes, for example, acrylic acid esters and derivatives thereof, methacrylic acid esters and derivatives thereof, styrene and derivatives thereof, organic carboxylic acid vinyl esters and derivatives thereof, organic carboxylic acid aryl esters and derivatives thereof, fumaric acid dialkyl esters and derivatives thereof, maleic acid dialkyl esters and derivatives thereof, itaconic acid dialkyl esters and derivatives thereof, organic carboxylic acid N-vinylamide derivatives, terminal unsaturated hydrocarbons and derivatives thereof, organic germanium derivatives containing an unsaturated hydrocarbon group, and vinyl-1,3-dioxolan-2-one and derivatives thereof.

The kind of the polymerizable monomer which is used as the raw material of another repeating unit is selected appropriately depending on properties which are required for a gate insulating layer or an overcoat layer. Polymerizable monomers having a high molecular density and forming a hard film such as styrene and derivatives thereof are selected, since its durability against a solvent is excellent and the hysteresis of an organic film transistor decreases. Further, polymerizable monomers imparting plasticity such as methacrylic acid esters and derivatives thereof and acrylic acid esters and derivatives thereof are selected, since close adherence with a gate electrode and an adjacent layer is excellent.

The acrylic acid esters and derivatives thereof may be a monofunctional acrylate or a polyfunctional acrylate. The acrylic acid esters and derivatives thereof include, for example, methyl acrylate, ethyl acrylate, n-propyl acrylate, isopropyl acrylate, n-butyl acrylate, isobutyl acrylate, sec-butyl acrylate, hexyl acrylate, octyl acrylate, 2-ethylhexyl acrylate, decyl acrylate, isobornyl acrylate, cyclohexyl acrylate, phenyl acrylate, benzyl acrylate, 2-hydroxyethyl acrylate, 2-hydroxypropyl acrylate, 3-hydroxypropyl acrylate, 2-hydroxybutyl acrylate, 2-hydroxyphenylethyl acrylate, ethylene glycol diacrylate, propylene glycol diacrylate, 1,4-butanediol diacrylate, diethylene glycol diacrylate, triethylene glycol diacrylate, trimethylolpropane diacrylate, trimethylolpropane triacrylate, pentaerythritol pentaacrylate, 2,2,2-trifluoroethyl acrylate, 2,2,3,3,3-pentafluoropropyl acrylate, 2-(perfluorobutyl)ethyl acrylate, 3-perfluorobutyl-2-hydroxypropyl acrylate, 2-(perfluorohexyl)ethyl acrylate, 3-perfluorohexyl-2-hydroxypropyl acrylate, 2-(perfluorooctyl)ethyl acrylate, 3-perfluorooctyl-2-hydroxypropyl acrylate, 2-(perfluorodecyl)ethyl acrylate, 2-(perfluoro-3-methylbutyl)ethyl acrylate, 3-(perfluoro-3-methylbutyl)-2-hydroxypropyl acrylate, 2-(perfluoro-5-methylhexyl)ethyl acrylate, 2-(perfluoro-3-methylbutyl)-2-hydroxypropyl acrylate, 3-(perfluoro-5-methylhexyl)-2-hydroxypropyl acrylate, 2-(perfluoro-7-methyloctyl)ethyl acrylate, 3-(perfluoro-7-methyloctyl)-2-hydroxypropyl acrylate, 1H,1H,3H-tetrafluoropropyl acrylate, 1H,1H,5H-octafluoropentyl acrylate, 1H,1H,7H-dodecafluoroheptyl acrylate, 1H,1H,9H-hexadecafluorononyl acrylate, 1H-1-(trifluoromethyl)trifluoroethyl acrylate, 1H,1H,3H-hexafluorobutyl acrylate, N,N-dimethylacrylamide, N,N-diethylacrylamide and N-acryloyl morpholine.

The methacrylic acid esters and derivatives thereof may be a monofunctional methacrylate or a polyfunctional methacrylate. The methacrylic acid esters and derivatives thereof include, for example, methyl methacrylate, ethyl methacrylate, n-propyl methacrylate, isopropyl methacrylate, n-butyl methacrylate, isobutyl methacrylate, sec-butyl methacrylate, hexyl methacrylate, octyl methacrylate, 2-ethylhexyl methacrylate, decyl methacrylate, isobornyl methacrylate, cyclohexyl methacrylate, phenyl methacrylate, benzyl methacrylate, 2-hydroxyethyl methacrylate, 2-hydroxypropyl methacrylate, 3-hydroxypropyl methacrylate, 2-hydroxybutyl methacrylate, 2-hydroxyphenylethyl methacrylate, ethylene glycol dimethacrylate, propylene glycol dimethacrylate, 1,4-butanediol dimethacrylate, diethylene glycol dimethacrylate, triethylene glycol dimethacrylate, trimethylolpropane dimethacrylate, trimethylolpropane trimethacrylate, pentaerythritol pentamethacrylate, 2,2,2-trifluoroethyl methacrylate, 2,2,3,3,3-pentafluoropropyl methacrylate, 2-(perfluorobutyl)ethyl methacrylate, 3-perfluorobutyl-2-hydroxypropyl methacrylate, 2-(perfluorohexyl)ethyl methacrylate, 3-perfluorohexyl-2-hydroxypropyl methacrylate, 2-(perfluorooctyl)ethyl methacrylate, 3-perfluorooctyl-2-hydroxypropyl methacrylate, 2-(perfluorodecyl)ethyl methacrylate, 2-(perfluoro-3-methylbutyl)ethyl methacrylate, 3-(perfluoro-3-methylbutyl)-2-hydroxypropyl methacrylate, 2-(perfluoro-5-methylhexyl)ethyl methacrylate, 2-(perfluoro-3-methylbutyl)-2-hydroxypropyl methacrylate, 3-(perfluoro-5-methylhexyl)-2-hydroxypropyl methacrylate, 2-(perfluoro-7-methyloctyl)ethyl methacrylate, 3-(perfluoro-7-methyloctyl)-2-hydroxypropyl methacrylate, 1H,1H,3H-tetrafluoropropyl methacrylate, 1H,1H,5H-octafluoropentyl methacrylate, 1H,1H,7H-dodecafluoroheptyl methacrylate, 1H,1H,9H-hexadecafluorononyl methacrylate, 1H-1-(trifluoromethyl)trifluoroethyl methacrylate, 1H,1H,3H-hexafluorobutyl methacrylate, N,N-dimethylmethacrylamide, N,N-diethylmethacrylamide and N-acryloyl morpholine.

The styrene and derivatives thereof include, for example, styrene, 2,4-dimethyl-a-methylstyrene, o-methylstyrene, m-methylstyrene, p-methylstyrene, 2,4-dimethylstyrene, 2,5-dimethylstyrene, 2,6-dimethylstyrene, 3,4-dimethylstyrene, 3,5-dimethylstyrene, 2,4,6-trimethylstyrene, 2,4,5-trimethylstyrene, pentamethylstyrene, o-ethylstyrene, m-ethylstyrene, p-ethylstyrene, o-chlorostyrene, m-chlorostyrene, p-chlorostyrene, o-bromostyrene, m-bromostyrene, p-bromostyrene, o-methoxystyrene, m-methoxystyrene, p-methoxystyrene, o-hydroxystyrene, m-hydroxystyrene, p-hydroxystyrene, 2-vinylbiphenyl, 3-vinylbiphenyl, 4-vinylbiphenyl, 1-vinylnaphthalene, 2-vinylnaphthalene, 4-vinyl-p-terphenyl, 1-vinylanthracene, α-methylstyrene, o-isopropenyltoluene, m-isopropenyltoluene, p-isopropenyltoluene, 2,4-dimethyl-a-methylstyrene, 2,3-dimethyl-a-methylstyrene, 3,5-dimethyl-a-methylstyrene, p-isopropyl-a-methylstyrene, α-ethylstyrene, α-chlorostyrene, divinylbenzene, divinylbiphenyl, diisopropylbenzene and 4-aminostyrene.

The organic carboxylic acid vinyl esters and derivatives thereof include, for example, vinyl acetate, vinyl propionate, vinyl butyrate, vinyl benzoate and divinyl adipate.

The organic carboxylic acid aryl esters and derivatives thereof include, for example, aryl acetate, aryl benzoate, diaryl adipate, diaryl terephthalate, diaryl isophthalate and diaryl phthalate.

The fumaric acid dialkyl esters and derivatives thereof include, for example, dimethyl fumarate, diethyl fumarate, diisopropyl fumarate, di-sec-butyl fumarate, diisobutyl fumarate, di-n-butyl fumarate, di-2-ethylhexyl fumarate and dibenzyl fumarate.

The maleic acid dialkyl esters and derivatives thereof include, for example, dimethyl maleate, diethyl maleate, diisopropyl maleate, di-sec-butyl maleate, diisobutyl maleate, di-n-butyl maleate, di-2-ethylhexyl maleate and dibenzyl maleate.

The itaconic acid dialkyl esters and derivatives thereof include, for example, dimethyl itaconate, diethyl itaconate, diisopropyl itaconate, di-sec-butyl itaconate, diisobutyl itaconate, di-n-butyl itaconate, di-2-ethylhexyl itaconate and dibenzyl itaconate.

The organic carboxylic acid N-vinylamide derivatives include, for example, N-methyl-N-vinylacetamide.

The terminal unsaturated hydrocarbons and derivatives thereof include, for example, 1-butene, 1-pentene, 1-hexene, 1-octene, vinylcyclohexane, vinyl chloride and aryl alcohol.

The organic germanium derivatives containing an unsaturated hydrocarbon group include, for example, aryltrimethylgermanium, aryltriethylgermanium, aryltributylgermanium, trimethylvinylgermanium and triethylvinylgermanium.

The vinyl-1,3-dioxolan-2-one and derivatives thereof include, for example, 4-vinyl-1,3-dioxolan-2-one and 5-methyl-4-vinyl-1,3-dioxolan-2-one.

The polymerizable monomer which is used as the raw material of another repeating unit is preferably an acrylic acid alkyl ester, a methacrylic acid alkyl ester, styrene, 4-methoxystyrene, acrylonitrile, methacrylonitrile, aryltrimethylgermanium or 4-vinyl-1,3-dioxolan-2-one.

The amount of the repeating unit having a group represented by the formula (1) contained in a polymer compound (A) is preferably 20 mol% or more and 70 mol% or less, more preferably 30 mol% or more and 60 mol% or less, with respect to all repeating units contained in the polymer compound (A). The repeating unit having a group represented by the formula (1) is preferably a repeating unit represented by the formula (2).

The polystyrene-equivalent weight-average molecular weight of the polymer compound (A) is preferably 3000 to 1000000, more preferably 5000 to 500000.

The polymer compound (A) includes, for example, poly(α-methyl-4-[dimethyl-(2-pyranyl-oxycarbonyl)]methyloxy benzyl-methacrylate-co-styrene), poly(α-methyl-4-[dimethyl-(2-pyranyl-oxycarbonyl)]methyloxy benzyl-methacrylate-co-acrylonitrile), poly(α-methyl-4-[dimethyl-(2-pyranyl-oxycarbonyl)]methyloxy benzyl-methacrylate-co-4-methoxystyrene), poly(α-methyl-4-[dimethyl-(2-pyranyl-oxycarbonyl)]methyloxy benzyl-methacrylate-co-2,3,4,5,6-pentafluorostyrene) and poly(α-methyl-4-[dimethyl-(2-pyranyl-oxycarbonyl)]methyloxy benzyl-methacrylate-co-methyl methacrylate).

The number of the polymer compound (A) contained in the composition of the present invention may be one, or may be two or more.

### <Compound 3(B)>

The compound (B) is a compound decomposing to generate an acid, by irradiation with an electromagnetic wave or an electronic beam or by heating.

The electromagnetic wave includes, for example, infrared ray, visible ray and ultraviolet radiation, preferably ultraviolet radiation. The wavelength of the electromagnetic wave is preferably 450 nm or less, more preferably 200 nm or more and 410 nm or less.

When the compound (B) is a compound decomposing to generate an acid by heating, the temperature for generating an acid is usually 200°C or less, preferably 100°C or more and 200°C or less, more preferably 120°C or more and 200°C or less.

The compound (B) includes, for example, a sulfonic acid ester compound, a triazine compound, an iodonium salt and a sulfonium salt.

The sulfonic acid ester compound is preferably a fluorinated alkyl sulfonic acid ester compound or a toluene sulfonic acid ester compound.

The fluorinated alkyl sulfonic acid ester compound includes, for example, N-hydroxynaphthalimide triflate, N-hydroxynaphthalimide perfluorobutyl triflate, N-hydroxyphthalimide triflate and N-hydroxyphthalimide perfluorobutyl triflate.

The toluene sulfonic acid ester compound includes, for example, α-(p-toluenesulfonyloxymethyl)benzoin, α-(p-toluenesulfonyloxy)-o-nitrotoluene and α-(p-toluenesulfonyloxy)-p-nitrotoluene.

The triazine compound includes, for example, 2,4-bis(trichloromethyl)-6-methyl-1,3,5-triazine, 2,4,6-tris(trichloromethyl)-1,3,5-triazine, 2,4-bis(trichloromethyl)-6-phenyl-1,3,5-triazine, 2,4-bis(trichloromethyl)-6-(4'-methoxyphenyl)-1,3,5-triazin e and 2,4-bis(trichloromethyl)-6-(3',4'-dimethoxyphenyl)-1,3,5-tr iazine.

The iodonium salt includes, for example, diphenyliodonium hexafluorophosphate, diphenyliodonium hexafluoroantimonate and tolylcumyliodonium tetrakis(pentafluorophenyl)borate.

The sulfonium salt includes, for example, triphenylsulfonium phosphate, p-(phenylthio)phenyldiphenylsulfonium hexafluorophosphate, triphenylsulfonium hexafluoroantimonate, p-(phenylthio)phenyldiphenylsulfonium hexafluoroantimonate, 4,4'-bis[di(β-hydroxyethoxy)phenylsulfonio]phenylsulfide-bi shexafluoroantimonate and 4-[4-(4-tert-butylbenzoyl)phenylthio]phenyldi(4-methylpheny 1)sulfonium hexafluorophosphate.

The compound (B) may be a compound described in JP-A No. 9-118663 or a compound described in JP-A No. 2007-262401.

Further, the compound (B) may also be a compound decomposing by irradiation with an electromagnetic wave or an electronic beam and decomposing to generate an acid by heating in which the temperature for generating an acid is over 200°C. In this case, it is preferably used together with a compound (B) in which the temperature for decomposing to generate an acid by heating is 200°C or less.

The number of the compound (B) contained in the composition of the present invention may be one, or may be two or more.

### <Compound (C)>

The compound (C) is a compound reacting with a hydroxyl group in the presence of an acid.

The compound (C) includes, for example, a melamine compound and a urea compound.

The melamine compound includes, for example, alkoxymethylmelamines (preferably, hexaalkoxymethylmelamines) such as hexamethoxymethylmelamine, hexaethoxymethylmelamine, hexabutoxymethylmelamine and the like; and poly(melamine-co-formaldehyde)methylated compounds.

The urea compound includes, for example, tetramethoxymethyl glycolurea and tetraethoxymethyl glycolurea.

The number of the compound (C) contained in the composition of the present invention may be one, or may be two or more.

The content of the compound (B) in the composition of the present invention is usually in the range of 0.01 part by weight to 30 parts by weight with respect to 100 parts by weight of the polymer compound (A). The content of the compound (C) is usually in the range of 1 part by weight to 50 parts by weight with respect to 100 parts by weight of the polymer compound (A).

### <Composition containing solvent>

The composition of the present invention may further contain a solvent, an additive and the like.

The solvent includes, for example, ether solvents such as tetrahydrofuran, diethyl ether and the like; aliphatic hydrocarbon solvents such as hexane and the like; alicyclic hydrocarbon solvents such as cyclohexane and the like; unsaturated hydrocarbon solvents such as pentene and the like; aromatic hydrocarbon solvents such as xylene and the like; ketone solvents such as acetone and the like; acetate solvents such as butyl acetate and the like; alcohol solvents such as isopropyl alcohol and the like; and halogen-based solvents such as chloroform and the like, and a mixture of these solvents may also be used.

When the composition of the present invention contains a solvent, the content of the solvent is usually in the range of 100 parts by weight to 900 parts by weight with respect to 100 parts by weight of the polymer compound (A).

The additive includes, for example, a sensitizer, a leveling agent and a viscosity modifier.

When the composition of the present invention contains an additive, the content of the additive is usually in the range of 0.01 part by weight to 20 parts by weight with respect to 100 parts by weight of the polymer compound (A).

The composition of the present invention is useful for formation of an insulating layer of an organic film transistor. The composition of the present invention is preferably used for formation of a gate insulating layer and/or an overcoat layer, more preferably used for formation of a gate insulating layer, among insulating layers of an organic film transistor.

Since the composition of the present invention comprises a polymer compound (A) containing a repeating unit having a group represented by the formula (1), an organic film transistor having an insulating layer formed shows little leak current and also manifests small dielectric tangent.

### <Organic film transistor>

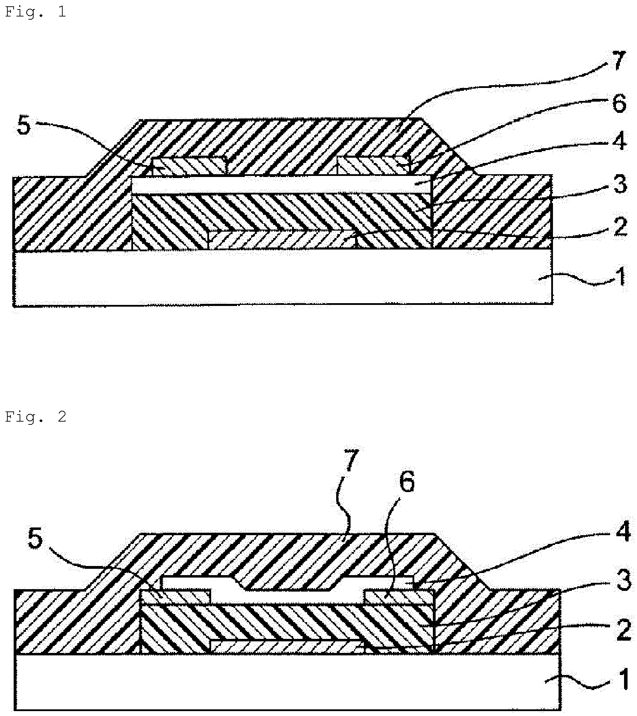

Fig. 1 is a schematic cross-sectional view showing the structure of a bottom gate top contact type organic film transistor as an embodiment of the present invention. This organic film transistor is equipped with a substrate 1, a gate electrode 2 formed on the substrate 1, a gate insulating layer 3 formed on the gate electrode 2, an organic semiconductor layer 4 formed on the gate insulating layer 3, a source electrode 5 and a drain electrode 6 formed sandwiching a channel part on the organic semiconductor layer 4, and an overcoat layer 7 covering the whole device.

The bottom gate top contact type organic film transistor can be produced, for example, by forming a gate electrode on a substrate, forming a gate insulating layer on the gate electrode, forming an organic semiconductor layer on the gate insulating layer, forming a source electrode and a drain electrode on the organic semiconductor layer, and finally, forming an overcoat layer. The composition of the present invention can be suitably used for forming a gate insulating layer. Further, the composition of the present invention can be suitably used also for forming an overcoat layer.

Fig. 2 is a schematic cross-sectional view showing the structure of a bottom gate bottom contact type organic film transistor as an embodiment of the present invention. This organic film transistor is equipped with a substrate 1, a gate electrode 2 formed on the substrate 1, a gate insulating layer 3 formed on the gate electrode 2, a source electrode 5 and a drain electrode 6 formed sandwiching a channel part on the gate insulating layer 3, an organic semiconductor layer 4 formed on the source electrode 5 and the drain electrode 6, and an overcoat layer 7 covering the whole device.

The bottom gate bottom contact type organic film transistor can be produced, for example, by forming a gate electrode on a substrate, forming a gate insulating layer on the gate electrode, forming a source electrode and a drain electrode on the gate insulating layer, forming an organic semiconductor layer on the source electrode and the drain electrode, and finally, forming an overcoat layer. The composition of the present invention can be suitably used for forming a gate insulating layer. Further, the composition of the present invention can be suitably used also for forming an overcoat layer.

### <Production method of film>

Formation of a gate insulating layer and/or an overcoat layer of an organic film transistor can be carried out by, for example,
a step of preparing a composition of the present invention containing a polymer compound (A), a compound (B), a compound (C) and a solvent (hereinafter, referred to also as an insulating layer application solution), applying the insulating layer application solution on a substrate, and if necessary, drying this, thereby forming a film,
a step of irradiating a part or several parts of the film with an electromagnetic wave or an electronic beam using a mask and the like, and if necessary, thermally treating the film,
a step of developing the part or several parts of the film irradiated with an electromagnetic wave or an electronic beam using an alkali developing solution or the like, thereby patterning the film, and
a step of subjecting the patterned film, that is, parts not irradiated with an electromagnetic wave or an electronic beam, to heating and the like, thereby crosslinking a compound contained in the film. The other crosslinking means than heating includes irradiation with an electromagnetic wave or an electronic beam. Further, after irradiation with an electromagnetic wave or an electronic beam, the film may also be crosslinked by performing heating.

Irradiation with an electromagnetic wave or an electronic beam is carried out at ambient temperatures, for example, 20°C to 35°C.

The composition of the present invention has photosensitivity, and can form a pattern on a film formed of an insulating layer application solution (hereinafter, referred to also as applied film). The applied film is, when a compound contained in the composition of the present invention is not yet crosslinked, easily dissolved, thus, a fine pattern can be formed with high accuracy in a short period of time.

In parts irradiated with an electromagnetic wave or an electronic beam in the applied film, a compound (B) decomposes to generate an acid and R of a group represented by the formula (1) in the polymer compound (A) (a monovalent organic group capable of dissociating from an oxygen atom by the action of an acid, for example, a monovalent organic group showing an activation energy in dissociating from an oxygen atom by the action of an acid of 80 kJ or less) dissociates from an oxygen atom, to generate an alkali-soluble group. The dissociating reaction may be promoted by heating.

Thereafter, when the applied film is immersed in an alkali developing solution, parts irradiated with an electromagnetic wave or an electronic beam are dissolved and removed, and a pattern of the form corresponding to parts not irradiated with an electromagnetic wave or an electronic beam is transferred to the applied film. The parts dissolved and removed act as via holes.

Thereafter, the applied film having a pattern transferred is subjected to heating and the like, thereby crosslinking a compound contained in the film. By heating at temperatures not lower than the thermal decomposition temperature of a compound (B), the compound (B) decomposes to generate an acid, the bond between an oxygen atom and a tertiary carbon atom of a group represented by the formula (1) in a polymer compound (A) breaks, thereby generating a hydroxyl group. This hydroxyl group reacts, in the presence of an acid generated by thermal decomposition of the compound (B), with a compound (C), to form a crosslinked structure.

Decomposition of the compound (B) may be conducted by irradiating with an electromagnetic wave or an electronic beam, or may be conducted by heating after irradiation with an electromagnetic wave or an electronic beam.

Here, "substrate" denotes a constituent member of an organic film transistor on which an insulating layer shall be formed. At the uppermost layer of the substrate, at least one of a gate electrode, a source electrode, a drain electrode and an organic semiconductor layer is formed.

The solvent to be contained in an insulating layer application solution is not particularly restricted providing it dissolves a polymer compound (A), a compound (B) and a compound (C), and solvents of which boiling point at normal pressure is 100°C or more and 200°C or less are preferable. The solvent of which boiling point at normal pressure is 100°C or more and 200°C or less includes, for example, 2-heptanone (boiling point: 151°C) and propylene glycol monomethyl ether acetate (boiling point: 146°C). The insulating layer application solution may contain a leveling agent, a surfactant, a curing catalyst and the like.

The insulating layer application solution can be applied on a substrate by a known application method such as a spin coat method, a die coater method, a screen printing method, an inkj et printing method and the like, and if necessary, it is dried. By drying, the solvent contained in the resin composition applied can be removed.

The mask is a member having a transmission part allowing transmission of an electromagnetic wave or an electronic beam and a block part blocking an electromagnetic wave or an electronic beam.

The wavelength of the electromagnetic wave for irradiation is preferably 450 nm or less, more preferably 200 nm or more and 410 nm or less. The electromagnetic wave is preferably ultraviolet radiation.

Irradiation with ultraviolet radiation can be carried using, for example, an exposure equipment used for production of a semiconductor and an UV lamp used for hardening an UV hardening resin. Irradiation with an electronic beam can be carried out using, for example, an extremely compact electronic beam irradiation tube.

Heating can be carried out using a heater, an oven and the like.

Since the photosensitivity of the composition of the present invention is usually positive, an alkaline solution is usually used as the developing solution. The alkaline solution may also be an alkaline developing solution usually used for developing a positive resist.

The alkaline solution is a solution prepared by dissolving an alkaline salt in an aqueous medium. The alkaline solution has pH10 or more, preferably pH10 to 14, more preferably pH11 to 14.

The aqueous medium contained in an alkaline solution as the developing solution includes, for example, water and, a solvent containing water and a water-soluble organic solvent. The water-soluble organic solvent includes, for example, acetone, methanol, ethanol, isopropanol and tetrahydrofuran. The content of the water-soluble organic solvent in the aqueous medium is usually 50% by weight or less, preferably 40% by weight or less, more preferably 30% by weight or less.

The alkaline salt contained in an alkaline solution as the developing solution includes, for example, tetramethylammonium hydroxide (TMAH), monoethanolamine, corrin, sodium hydroxide, potassium hydroxide and potassium carbonate.

When a patterned film is heated, the film is heated usually for 5 minutes or more and 120 minutes or less at temperatures not lower than the thermal decomposition temperature of a compound (B) generating an acid by thermal decomposition, and it is preferable that the film is heated for 10 minutes or more and 60 minutes or less. The temperature for heating a patterned film is preferably 80°C or more and 250°C or less, more preferably 100°C or more and 230°C or less, since the insulating layer to be formed is excellent in crosslinkability and insulating capacity.

A self-assembled monolayer may also be formed on a gate insulating layer of an organic film transistor. The self-assembled monolayer can be formed, for example, by treating a gate insulating layer using a solution prepared by dissolving an alkylchlorosilane compound or an alkylalkoxysilane compound at a concentration of 1 to 10% by weight in a solvent.

The alkylchlorosilane compound includes, for example, methyltrichlorosilane, ethyltrichlorosilane, butyltrichlorosilane, decyltrichlorosilane and octadecyltrichlorosilane.

The alkylalkoxysilane compound includes, for example, methyltrimethoxysilane, ethyltrimethoxysilane, butyltrimethoxysilane, decyltrimethoxysilane and octadecyltrimethoxysilane.

The substrate 1, the gate electrode 2, the source electrode 5, the drain electrode 6 and the organic semiconductor layer 4 may be constituted of usually used materials and methods. As the material of the substrate, a plate and a film made of a resin or a plastic, a glass plate, a silicon plate and the like are used. As the material of the electrode, chromium, gold, silver, aluminum, molybdenum and the like are used, and the electrode is formed by a known method such as a vapor deposition method, a sputtering method, a printing method, an inkjet method and the like.

As the organic semiconductor compound for forming the organic semiconductor layer 4, a n-conjugated polymer is used, and for example, polypyrrole type polymers, polythiophene type polymers, polyaniline type polymers, polyarylamine type polymers, fluorene type polymers, polycarbazole type polymers, polyindole type polymers and poly(p-phenylenevinylene) type polymers can be used.

As the organic semiconductor compound for forming the organic semiconductor layer 4, low molecular weight compounds having solubility in a solvent are also used, and for example, polycyclic aromatic derivatives such as pentacene and the like, phthalocyanine derivatives, perylene derivatives, tetrathiafulvalene derivatives, tetracyanoquinodimethane derivatives, fullerene compounds and carbon nanotube compounds can be used. Specific examples thereof include, a condensation compound of 2,1,3-benzothiadiazole-4,7-di(ethyleneboronate) with
2,6-dibromo(4,4-bishexadecanyl-4H-cyclopenta[2,1-b;3,4-b']dithiophene and a condensation compound of 9,9-di-n-octylfluorene-2,7-di(ethyleneboronate) with 5,5'-dibromo-2,2'-bithiophene.

For formation of an organic semiconductor layer, for example, an organic semiconductor compound is dissolved in a solvent to prepare an organic semiconductor application solution, and the organic semiconductor application solution is applied on a gate insulating layer, and if necessary, dried.

The solvent used in an organic semiconductor application solution is not particularly restricted providing it dissolves or disperses an organic semiconductor compound, and solvents having a boiling point at normal temperature of 50°C or more and 200°C or less are preferable. The solvent includes, for example, chloroform, toluene, anisole, 2-heptanone and propylene glycol monomethyl ether acetate. The organic semiconductor application solution can be applied on a gate insulating layer by a known method such as a spin coat method, a die coater method, a screen printing method, an inkjet printing method and the like, like the insulating layer application solution.

The organic film transistor of the present invention may have an overcoat layer for the purpose of protecting an organic semiconductor layer and enhancing smoothness of the surface. The overcoat layer may also be a layer formed of the composition of the present invention.

On an insulating layer formed of the composition of the present invention, a flat film and the like can be laminated, and a laminated structure can be formed easily. For example, on an insulating layer, an organic electroluminescent device can be suitably mounted.

### EXAMPLES

The present invention will be illustrated by examples below, but the present invention is not limited to the examples.

### Synthesis Example 1

### (Synthesis of compound 1)

A Dimroth condenser equipped on its upper part with a three way cock and an electromagnetic induction type stirring blade were attached to a 1000 ml three-necked flask. Into this three-necked flask were added 20.00 g of 3-aminophenol (manufactured by Tokyo Chemical Industry Co., Ltd.), 71.50 g of ethyl 2-bromoisobutyrate (manufactured by Tokyo Chemical Industry Co., Ltd.), 36.65 g of sodium hydroxide (manufactured by Wako Pure Chemical Industries, Ltd.) and 400 ml of methylisobutyl ketone (manufactured by Wako Pure Chemical Industries, Ltd.), then, the three-necked flask was immersed in an oil bath of 50°C, and they were reacted for 6 hours while stirring the stirring blade by a mechanical stirrer.

The resultant reaction solution was cooled down to room temperature, then, 21 g of acryloyl chloride (manufactured by Tokyo Chemical Industry Co., Ltd.) was dropped over a period of 30 minutes by a gas tight syringe while continuing stirring. After completion of dropping, they were reacted for 12 hours while stirring at room temperature.

To the resultant reaction solution was added 100 mL of ion exchanged water, then, concentrated hydrochloric acid was added until pH of the aqueous layer reached 2. The resultant reaction mixture (1000 ml) transferred into a separating funnel, and the organic layer was liquid-separated. To the resultant organic layer was added 200 mL of ion exchanged water, then, sodium bicarbonate was added until the aqueous layer became neutral, and the aqueous layer was liquid-separated. The resultant aqueous layer was acidified with dilute hydrochloric acid, then, the resultant deposit was extracted with 200 mL of methyl isobutyl ketone, and the organic layer was liquid-separated. The resultant organic layer was washed with 50 ml of ion exchanged water three times, then, dried over anhydrous magnesium sulfate. After drying, the salt was separated by filtration, and the resultant organic layer transferred into a 500 ml eggplant-shaped flask, and concentrated by a rotary evaporator, to obtain a brown viscous material.

Into the eggplant-shaped flask containing the resultant brown viscous material, a stirring bar was added, and further, 100 mL of 3,4-dihydro-2H-pyran (manufactured by Aldrich) was added, then, the mixture was stirred. To the resultant reaction solution was added a catalytic amount of concentrated hydrochloric acid, and the solution was reacted for 12 hours at room temperature while stirring the stirring bar by a magnetic stirrer.

To the resultant reaction mixture, 100 mL of a saturated sodium bicarbonate aqueous solution was added to neutralize the mixture, then, 200 mL of methyl isobutyl ketone was added and the organic layer was extracted. An operation of washing the resultant organic layer with 50 mL of a saturated sodium bicarbonate aqueous solution and performing liquid separation was repeated twice, then, the product was dried over anhydrous magnesium sulfate. Thereafter, an insoluble material was separated by filtration and methyl isobutyl ketone was distilled off by a rotary evaporator, to obtain a compound 1 as a viscous liquid. The amount of the compound 1 obtained was 30.0 g.

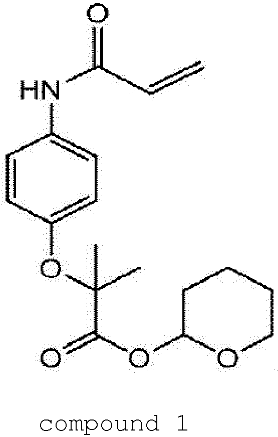

### Synthesis Example 2

### (Synthesis of polymer compound 1)

Into a 50 ml pressure vessel (manufactured by ACE GLASS Inc.) were added 5.00 g of the compound 1, 1.56 g of styrene (manufactured by Wako Pure Chemical Industries, Ltd.), 2.68 g of 4-vinylanisole (manufactured by Aldrich), 0.05 g of 2,2'-azobis(2-methylpropionitrile) and 14.06 g of 2-heptanone (manufactured by Tokyo Chemical Industry Co., Ltd.), then, the mixture was bubbled with an argon gas to remove dissolved oxygen, and the vessel was sealed tightly. The pressure vessel was immersed into an oil bath of 80°C, and the mixture was reacted for 6 hours, to obtain a viscous 2-heptanone solution containing the polymer compound 1 dissolved. The polymer compound 1 is a polymer compound containing the following repeating unit. The numeral appended to a parenthesis denotes the mol fraction of the repeating unit.

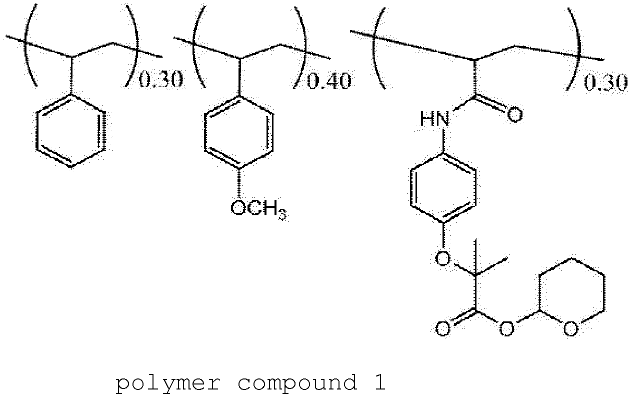

### Example 1

### (Material of organic film transistor insulating layer and production of MIM device)

Into a 10 ml sample bottle were added 1.00 g of the 2-heptanone solution of the polymer compound 1 obtained in Synthesis Example 2, 0.02 g of a compound represented by the following formula ("MBZ-101" manufactured by Midori Kagaku Co., Ltd.) as a photoacid generating agent, 0.042 g of hexamethoxymethylmelamine ("MW-390" manufactured by Sanwa Chemistry Co., Ltd.) and 2.00 g of 2-heptanone, and these were dissolved while stirring, to prepare an application solution 1.

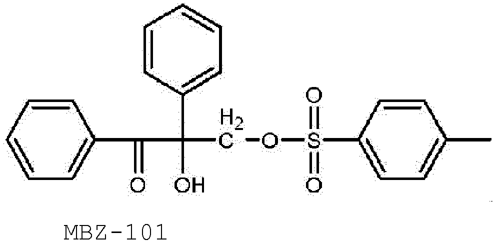

The resultant application solution 1 was filtrated through a membrane filter having a pore diameter of 0.45 µm, then, spin-coated on a glass substrate equipped with a chromium electrode. Thereafter, the coated material was dried at 90°C for 1 minute on a hot plate, to form an applied layer. Thereafter, the applied layer was irradiated with 1600 mJ/cm² UV light (wavelength: 365 nm) via a mask having a 25 µm square aperture using an aligner (PLA-521, manufactured by CANON Inc.). Thereafter, the layer was post-baked at 90°C for 2 minutes on a hot plate and immersed in a positive developing solution (5 wt% corrin aqueous solution) to remove exposed parts, thereby attaining development. The resultant glass substrate was washed with ion exchanged water, dried by a spin drier, then, baked hard at 150°C for 30 minutes on a hot plate under a nitrogen gas atmosphere, to obtain a gate insulating layer having via holes.

<Evaluation of resist property>

The resist property of the application solution 1 was evaluated. By using the application solution 1, via holes can be formed on the gate insulating layer at a resolution of 25 µm square.

On the resultant gate insulating layer, an aluminum electrode was formed by vapor deposition using a metal mask, thereby fabricating an MIM (Metal Insulator Metal) device.

### <Evaluation of electric characteristic of MIM device>

The dielectric loss and the breakdown voltage of the fabricated MIM device were measured using a vacuum prober (BCT22MDC-5-HT-SCU; manufactured by Nagase Electronic Equipments Service Co., LTD.). Here, the voltage resistance was evaluated by the electric field intensity at which the leak current was 1×10⁻⁶ A/cm² when electric field was applied between electrodes.

**Table 1**

| | electric characteristic | | | |
|---|---|---|---|---|
| | dielectric loss | | | voltage resistance |
| | 10 kHz | 100 kHz | 1 MHz | |
| Example 1 | 0.009 | 0.010 | 0.021 | 2.8 MV/cm |

It has been found that via holes can be formed on a gate insulating layer or an overcoat layer by a simple process by using the composition of the present invention. Further, it has been found that a gate insulating layer or an overcoat layer formed of the composition of the present invention is excellent in dielectric loss and breakdown voltage.

### Industrial Applicability

The present invention can provide a material capable of forming via holes on a gate insulating layer or an overcoat layer by a simple process. Further, according to a preferable embodiment, the present invention can provide a material capable of forming a gate insulating layer or an overcoat layer excellent in dielectric loss and breakdown voltage.

### Explanation of reference numerals

- 1: substrate
- 2: gate electrode
- 3: gate insulating layer
- 4: organic semiconductor layer
- 5: source electrode
- 6: drain electrode
- 7: overcoat layer

## Claims

1. A composition comprising a polymer compound (A) containing a repeating unit having a group represented by the following formula (1), a compound (B) decomposing to generate an acid by irradiation with an electromagnetic wave or an electronic beam or by heating, and a compound (C) reacting with a hydroxyl group in the presence of an acid: 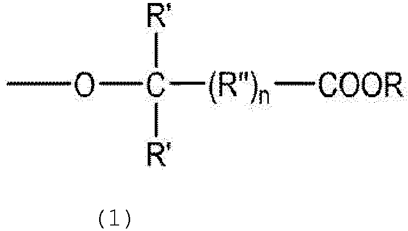 [wherein
R represents a monovalent organic group showing an activation energy in dissociating from an oxygen atom by the action of an acid of 80 kJ or less.
R' represents an alkyl group or a cycloalkyl group, and these groups may have a substituent. A plurality of R' may be the same or different, and may be combined together to form a ring together with a carbon atom to which they are attached.
n represents an integer of 0 or more.
R" represents an alkylene group, a cycloalkylene group or an arylene group, and these groups may have a substituent. When there are a plurality of R", they may be the same or different. R' and R" may be combined together to form a ring together with a carbon atom to which they are attached.].

2. The composition according to Claim 1, wherein the repeating unit having a group represented by the formula (1) is a repeating unit represented by the following formula (2) : 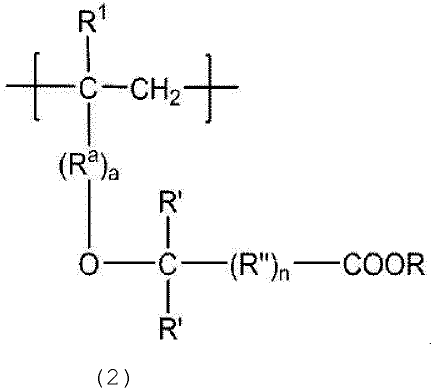 [wherein
R, R', R" and n represent the same meaning as described above.
R¹ represents a hydrogen atom or a methyl group.
a represents an integer of 0 or more.
R^{a} represents an alkylene group, a cycloalkylene group, an arylene group, a group represented by -CO-, a group represented by -COO-, a group represented by -NHCO- or a group represented by -NHCOO-, and these groups may have a substituent. When there are a plurality of R^{a}, they may be the same or different.].

3. The composition according to Claim 1 or 2, wherein the compound (B) is a sulfonic acid ester compound, a triazine compound, a sulfonium salt or an iodonium salt.

4. The composition according to any one of Claims 1 to 3, wherein the compound (C) is a melamine compound or a urea compound.

5. The composition according to any one of Claims 1 to 4, further comprising a solvent.

6. A method of producing a film, comprising a step of applying the composition according to Claim 5 on a substrate, to form a film, a step of irradiating a part or several parts of the film with an electromagnetic wave or an electronic beam, a step of developing the part or several parts of the film irradiated with an electromagnetic wave or an electronic beam, thereby patterning the film, and a step of heating the patterned film, thereby cross-linking a compound contained in the film.

7. A method of producing a film, comprising a step of applying the composition according to Claim 5 on a substrate, to form a film, a step of irradiating a part or several parts of the film with an electromagnetic wave or an electronic beam, a step of developing the part or several parts of the film irradiated with an electromagnetic wave or an electronic beam, thereby patterning the film, and a step of irradiating the patterned film with an electromagnetic wave or an electronic beam, then, heating the film, thereby cross-linking a compound contained in the film.

8. The method of producing a film according to Claim 6 or 7, wherein the electromagnetic wave is ultraviolet radiation.

9. A film produced by the production method according to any one of Claims 6 to 8.

10. An organic film transistor having the film according to Claim 9 in an insulating layer.

11. The organic film transistor according to Claim 10, wherein the insulating layer is a gate insulating layer and/or an overcoat layer.

12. A polymer compound comprising a repeating unit having a group represented by the following formula (1): 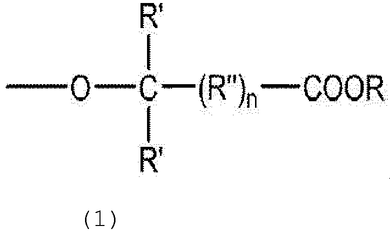 [wherein
R represents a monovalent organic group showing an activation energy in dissociating from an oxygen atom by the action of an acid of 80 kJ or less.
R' represents an alkyl group or a cycloalkyl group, and these groups may have a substituent. A plurality of R' may be the same or different, and may be combined together to form a ring together with a carbon atom to which they are attached.
n represents an integer of 0 or more.
R" represents an alkylene group, a cycloalkylene group or an arylene group, and these groups may have a substituent. When there are a plurality of R", they may be the same or different. R' and R" may be combined together to form a ring together with a carbon atom to which they are attached.].
